# EUROPÄISCHE PATENTANMELDUNG

(11) **EP 1 085 580 A2**
(43) Veröffentlichungstag der Anmeldung: **21.03.2001**
(21) Anmeldenummer: 00118246.8
(22) Anmeldetag: 04.09.2000
(51) Int. Cl.: H01L 31/045, H01L 31/05

(54) **Flexibler Solargenerator**

(30) Priorität: 16.09.1999 DE 19944414
(71) Anmelder: EADS Deutschland GmbH, 81663 München (DE)
(72) Erfinder: Küchler, Gunter, 25489 Haselau (DE)

(57) **Zusammenfassung**

Aufgabe der Erfindung ist es eine sichere und kostengünstige elektrische Verschaltung für die leitfähigen Rückseiten eines flexiblen Solargenerators zu schaffen.

Diese Aufgabe wird erfindungsgemäß dadurch gelöst, daß die Scharnierröhrchen (4) der Scharniere (3) des Solargenerators aus elektrisch leitfähigem Material bestehen, daß sie elektrisch leitend auf den Rändern der leitfähigen Rückseiten der Blankets (2) befestigt sind und daß die Scharnierrörchen mit einem elektrisch leitfähigen Scharnierstift (7) mechanisch verbunden sind.

Die Erfindung findet Anwendung bei der Verschaltung von leitfähigen Rückseiten eines flexiblen Solargenerators, der mindestens ein Array bestehend aus mehreren mit klavierbandartigen Scharnieren verbundenen Blankets aufweist.

## Beschreibung

Die Erfindung betrifft eine Verschaltung von leitfähigen Rückseiten eines flexiblen Solargenerators gemäß dem Oberbegriff des Patentanspruchs 1.

Die Rückseiten flexibler Solargeneratoren müssen für bestimmte Einsatzfälle elektrisch leitend ausgeführt werden, um das Ableiten von elektrostatischen Aufladungen zu ermöglichen. Dazu werden die mit Solarzellen bestückten Trägerfolien - die sogenannten "Blankets" - auf ihrer Rückseite entweder leitfähig beschichtet oder es werden elektrisch leitfähige Trägerfolien - wie z.B. "schwarzes Kapton" - als Blankets eingesetzt. In einem Array eines flexiblen Solargenerators - das mehrere Blankets mit Scharnieren zusammenfaßt - müssen die elektrisch leitfähigen Flächen der Blankets über die Scharnierverbindungen hinweg elektrisch leitend miteinander verbunden sein. Es ist bekannt, diese elektrische Verbindungen mit zusätzlichen Brückenelementen herzustellen. Diese zusätzlichen Brückenelemente können bei mechanischen und thermischen Beanspruchungen zu Betriebsausfällen führen und ihre Verwendung ist mit Mehrkosten für die Brückenelemente selbst und für ihren infolge der Qualitätsanforderungen aufwendigen Einbau verbunden.

Aufgabe der Erfindung ist es eine sichere und kostengünstige elektrische Verschaltung für die leitfähigen Rückseiten eines flexiblen Solargenerators zu schaffen.

Diese Aufgabe wird erfindungsgemäß durch die Merkmale des Patentanspruchs 1 gelöst. Weiterbildungen der Erfindung sind in den Unteransprüchen angegeben.

Die erfindungsgemäße Verschaltung ist in der Lage über die gesamteLebensdauer eines flexiblen Solargenerators, der z.B. im Low Earth Orbit 36000 thermischen Zyklen von +100 grad C bis - 100 grad C oder im geostationären Orbit 2000 thermischen Zyklen von +100 grad C bis - 180 grad C ausgesetzt sein kann, zu funktionieren und die üblichen Falt- und Entfaltvorgänge bzw. Roll- und Entrollvorgänge im Zusammenhang mit Tests, mit der Systemntegration, dem Verstauen auf der Erde und dem Entfalten bzw. Entrollen im Orbit ohne Beschädigung zu überstehen. Weiterhin ist es bei der erfindungsgemäßen Verschaltung von kostengünstigem Vorteil, daß keine zusätzlichen Überbrückungselemente und die dafür erforderlichen Fertigungschritte benötigt werden. Erfindungsgemäß werden die Scharnierverbindungen zwischen den Blankets zusätzlich auch als elektrische Verbindungen für die elektrisch leitfähigen Rückseiten der Blankets benutzt.

Anhand der Zeichnung wird nachstehend ein Ausführungsbeispiel der Erfindung näher erläutert:
- Fig. 1: zeigt den Aufbau eines Arrays von einem flexiblen Solargenerator und
- Fig. 2: zeigt die erfindungsgemäße Verschaltung der leitfähigen Rückseiten eines Arrays.

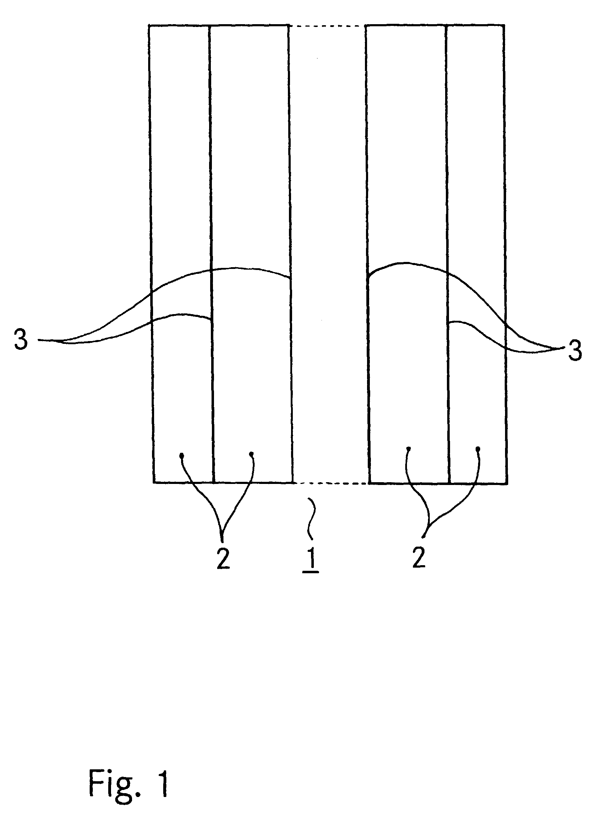

Das in Fig. 1 gezeigte Array 1 eines flexiblen Solargenerators besteht aus mehreren Blankets 2, die mit klavierbandartigen Scharnieren 3 faltbar miteinander verbunden sind. In Fig. 1 sind durch die punktierten Linien symbolisch angedeutet, daß ein Array 1 üblicherweise aus mehr als vier Blankets 2 besteht, deren Darstellung dadurch in Fig. 1 zeichnerisch vereinfacht worden ist.

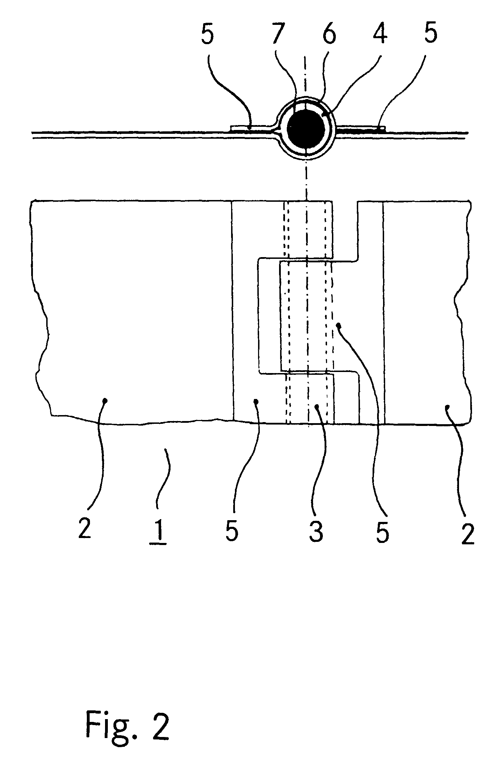

Fig. 2 zeigt einen Ausschnitt aus der Verschaltung der leitfähigen Rückseiten aneinandergrenzender Blankets 2 in einem Arrays 1. Die Verschaltung wird erfindungsgemäß unter Verwendung der Scharniere 3 hergestellt, die zu diesem Zweck aus elektrisch leitfähigem Material hergestellt sind. Die Scharnierröhrchen 4 der Scharniere 3 sind zu diesem Zweck mittels einer elektrisch leitfähigen Klebung 6 auf aneinandergrenzenden Rändern der elektrisch leitenden Rückseiten der Blankets 2 fixiert. Dadurch ist eine elektrische Verbindung von der leitfähigen Rückseite der Blankets zu den Innenflächen aller Scharnierröhrchen 4 hergestellt.

Das klavierbandartige Scharnier 3 wird durch ein mechanisches Verbinden der Scharnierröhrchen 4 mit einem durchgehenden Scharnierstift 7 hergestellt, der ebenfalls aus elektrisch leitfähigem Material besteht, womit eine sichere Verschaltung der elektrisch leitfähigen Rückseiten der Blankets 2 über die Scharniere 3 hinweg realisiert ist.

Im Ausführungsbeispiel der Fig. 2 sind die Scharnierröhrchen 4 durch ein Umklappen der mit elektrisch leitfähigem Kleber vorbereiteten Blanketränder um die Scharnierröhrchen 4 hergestellt, so daß diese in dadurch gebildeten Taschen 5 aufgenommen sind. Es sind aber auch alternative Ausführungen für die Fixierung der Scharnierröhrchen 4 an den Blanketrändern denkbar; z.B. durch Nietung, Klemmung oder einer Nähverbindung.

## Patentansprüche

1. Verschaltung eines flexiblen Solargenerators, der mindestens ein Array bestehend aus mehreren mit klavierbandartigen Scharnieren verbundenen Blankets aufweist, wobei die Scharnierröhrchen (4) der Scharniere (3) aus elektrisch leitfähigem Material bestehen, elektrisch leitend auf den Rändern der Rückseiten der Blankets (2) befestigt sind, die Scharnierröhrchen mit einem elektrisch leitfähigen Scharnierstift (7) mechanisch verbunden sind und die Rückseiten der Blankets (2) leitfähig ausgebildet sind.

2. Verschaltung nach Anspruch 1, **dadurch gekennzeichnet,** daß die Scharnierröhrchen (4) mittels einer elektrisch leitfähigen Klebung auf den Rändern der Blankets fixiert sind.

3. Verschaltung nach Anspruch 1 oder 2, **dadurch gekennzeichnet,** daß die Scharnierröhrchen (4) in Taschen (5) fixiert sind, die durch ein Umklappen der Blanketränder mit ihren elektrisch leitfähigen Rückseiten um die Scharnierröhrchen (4) erzeugt sind.
